# EUROPEAN PATENT SPECIFICATION

(11) **EP 2 960 923 B1**
(45) Date of publication and mention of the grant of the patent: **12.04.2023**
(21) Application number: 15173735.0
(22) Date of filing: 25.06.2015
(51) Int. Cl.: H01H 71/04, H01H 1/20, H01H 1/00

(54) **SWITCHING ARRANGEMENT**
SCHALTANORDNUNG
AGENCEMENT DE COMMUTATION

(30) Priority: 25.06.2014 DE 102014212132
(43) Date of publication of application: 30.12.2015
(73) Proprietor: TE Connectivity Germany GmbH, 64625 Bensheim (DE)
(72) Inventor: Kroeker, Matthias, 15749 Mittenwalde (DE); Lindner, Christian, 13187 Berlin (DE); Koch, Harry, 12105 Berlin (DE)
(74) Representative: Grünecker Patent- und Rechtsanwälte PartG mbB

(56) References cited:
- WO-A1-2012/116824
- DE-A1- 19 941 108
- DE-A1-102004 053 612
- DE-A1-102010 043 352
- US-A- 4 608 620
- US-A1- 2008 036 561
- US-A1- 2013 335 174

## Description

The invention relates to a switching arrangement, in particular for the high-voltage and/or high-current region, with two contacts and a switching device, which can be moved into a separated position in which the contacts are electrically separated from one another. The present invention further relates to a method for measuring the switching state of a switching arrangement with two contacts and a switching device, which can be moved into a rest position in which the contacts are electrically separated from one another.

Such switching arrangements are used, for example, in electrically operated cars. In order to ensure that, for example, no dangerous voltages are present in the case of maintenance work, it is necessary to be able to detect that the switching arrangement is adequately insulated. In the case of a previous method, measurement is thereby carried out directly in the electric circuit. In this case, auxiliary relays serve to couple measurement devices to the circuit. This is, however, very complex.

In the case of a different previous method, the position of the switching device is sensed with a micro-switch. This is, however, unreliable since parts of the micro-switch can break down and the switching arrangement can be influenced as a result, so that it no longer functions reliably. Moreover, such a solution is often not permissible since high voltage can be present at the micro-switch under certain circumstances.

In order to provide a solution with which it is possible to easily and reliably ascertain whether the switching arrangement is insulated, the presence of the switching device in the separated position is detected by a contact-free measurement of the position of the switching device. For this purpose, a switching arrangement comprises a detector with which the presence of the switching device in the separated position can be detected in a contact-free manner.

This solution has the advantage that it is simpler than the measurement known from the prior art with auxiliary relays. Moreover, the contactless measurement prevents high voltages or current from being able to be transmitted to the detector. Moreover, a defect in the detector does not lead to impairments of the switch. This solution is therefore also more reliable. From US 2013/0335174 A1, an electromagnetic opening/closing device including a detector for detecting an opened or closed state of the contact unit is known. DE 10 2010 043352 A1 shows a contact assembly for the relay having two current paths. DE 10 2004 053612 A1 discloses a monitoring method for two contact pieces. In DE 199 41 108 A1, an auxiliary switch for a switching device or safety switch is shown. WO 2012/116824 A1 shows an electromagnetic relay having a monitored switching position. In US 4608620 a relay is shown that is opened and closed with an electromagnet and in which a Hall sensor is used to detect whether a magnetic circuit is open or closed. US 2008/036561 A1 shows several devices that allow to check whether the circuit of a relay has been opened correctly or whether a fault, in particular a welding of the contacts, has occurred by checking whether the armature has passed a defined opening point.

The detector that performs measurement in a contact-free manner, is a magnetic field sensor, namely a hall sensor, wherein depending on the position of an armature, a magnetic circuit is closed or open.

This configuration allows a simple and reliable measurement.

It is the object of the invention to provide a solution that allows a detection of wear and tear of the switching device or the contacts over longer periods of time.

According to the invention, this is achieved by the switching arrangement as defined in independent claim 1 and the method as defined in independent claim 8. Preferred embodiments of the invention are defined in the dependent claims. The detector is configured to detect an infinite number of intermediate positions between the separated position (I) and the bridging position so that a determination of the position of the switching device in a continuous region between the separated position and a bridging position and is characterized in that the switching arrangement is adapted to identify a wear of the switching device or the contacts by measurement of the position of the armature. In an inventive method, the position of the armature is determined in a continuous region between the rest position and the bridging position and a wear of the switching arrangement and/or the switching device is identified by an evaluation of signals of the detector in the continuous region.

The solution according to the invention can be further improved with the following configurations and further developments which are themselves each advantageous and which can be combined with one another as desired.

The switching device can be movable into a bridging position in which the contacts are connected to one another in an electrically conductive manner by the switching device. In order to also be able to ascertain whether the switching device is located in the bridging position, the detector is configured so that the presence of the switching device in the bridging position is detected in a contact-free manner with said detector. In a corresponding method, the presence of the switching device in the bridging position is detected by a contact-free measurement of the position of the switching device.

Not only the presence in the separated position and/or the bridging position, but rather also in the positions lying therebetween is detected with an appropriately configured detector. In particular, the detector is configured to detect an infinite number of intermediate positions so that a determination of the position of the switching device in a continuous region between bridging position and separated position is possible.

As the detector allows a sufficiently high resolution of the position, wear and tear of the switching device or the contacts which occurs over longer periods of time can thus also be detected with it. As a result, wear can be identified. If there is an appropriately high temporal resolution of the detector, such wear measurement could also be carried out by measuring the position of the switching device or of an element which drives the switching device at specific points in time. Such points in time are in particular the establishment of contact between the contacts by the switching device and the occupation of the end position of the switching device and/or of an element which drives the switching device.

The contacts can be arranged in a contact switching chamber. As a result, protection of the contacts from influences from the outside and protection of other elements from the contacts can be achieved. The switching arrangement can be a relay or a protection device.

The switching arrangement can have a signal-permeable wall region which is permeable for the signals which can be detected by the detector. This can, for example, be a recess or opening in a wall or part of a wall or form a wall. Such a wall can be a housing wall, for example, an outer or inner housing wall.

The switching device can comprise a drive for a contact bridge. The detector can be directed towards the drive. A detection of the separated state can be carried out without having to record the contact bridge itself. In particular, the detector can be arranged on the side of the drive which faces away from the contacts. A wall region can be present between the detector and the drive, which wall region is permeable for the signals which can be detected by the detector. This enables a simple and compact design.

The drive can be arranged between the contact bridge and the wall region which is permeable for the signals which can be detected by the detector. The drive can be arranged between the contact bridge and the detector. The detector can be arranged on the side of the switching arrangement which lies opposite the contact bridge in relation to the drive. As a result, in each case a compact configuration can be enabled.

The switching device comprises an armature arranged in a coil and the position of the armature can be able to be detected with the detector in a contact-free manner. The armature can be connected in a positive locking manner, in particular rigidly to the rest of the switching device so that the position of the switching device can be concluded from the position of the armature and in particular the presence of the switching device in the separated position can be identified. The armature can serve to drive the switching device. Depending on whether a current flows through the coil and on which strength and orientation the current has, the coil can attempt to move the switching device into the separated position or into the bridging position or out thereof. Here, the armature therefore not only satisfies the function that it transmits the force and/or the movement to the switching device, but rather simultaneously serves as an indicator element for the position of the switching device.

The signal-permeable wall region can be arranged in the region of the drive, in particular in the region of the coil. For example, it can be arranged in the region of a rear side of a coil. An element of the drive coupled to the switching device, in particular to the contact bridge, can be able to be sensed by the signal-permeable wall region. The element can be sensed in particular directly, i.e. without intermediate elements. This enables a simple construction.

The detector can be arranged outside and the contacts inside a housing. In particular, the housing can comprise a contact switching chamber. If the detector is not arranged in the same housing, in particular not in or close to a contact switching chamber, it is not exposed to the loads which occur as a result of the switching, for example, arc formation. As a result of this, the detector is protected and can be used for longer. The detector can be designed without a housing. The detector can be arranged outside a housing in which the contacts are arranged. It can, for example, be accommodated in a separate housing or have its own housing. This can enable easy separation of the contacts from the detector.

The position of the switching device can be permanently monitored. A special measurement step can be omitted, as a result of which operation is simplified.

The switching arrangement can comprise a housing. The housing can in turn comprise a high-voltage region and a low-voltage region, wherein the contacts are arranged in the high-voltage region and the detector is arranged in the low-voltage region. As a result, a separation of high voltage and low voltage can be achieved. The housing can be as a whole gas- and/or liquid-impervious and prevent the ingress of dust. Moreover, the housing can be high-voltage-impervious so that no dangerous high voltages can escape out of the housing.

In a first configuration, the high-voltage region and the low-voltage region can be connected to one another. For example, both regions can be situated in a single chamber. For example, the contacts can thus be arranged on one side of the housing and the detector can be arranged on an opposite side of the housing in each case internally in the housing so that the detector can detect the position of the switching device without, however, having a direct contact to the switching device.

In a further configuration, the high-voltage region and the low-voltage region can be separated from one another by a gas- and/or liquid-impervious, signal-permeable wall region. In particular, such a wall region can prevent the penetration of high voltage into the low-voltage region. The wall region is simultaneously permeable for the signals used in the contact-free measurement with the detector. In the case of a measurement with electromagnetic waves, the wall region can be permeable for the electromagnetic waves. It can be produced from a dielectric medium or from a magnetically permeable material. This can be, for example, a transparent window or a transparent partition if the measurement is carried out optically, which is not covered by the present invention. In the case of a magnetic measurement, the wall region can be magnetically permeable or conductive.

The signal-permeable wall region can be a partition which divides an otherwise open chamber into two parts. In another configuration, the signal-permeable wall region is a window of a wall which separates the high-voltage region from the low-voltage region from one another. In the case of both configurations, the high-voltage region and the low-voltage region are reliably separated from one another so that the high voltages cannot penetrate into the low-voltage region. The risk of damage to electric elements or injuries to users is therefore reduced.

In a further advantageous configuration, the contacts are arranged in a high-voltage housing and/or the detector is arranged in a low-voltage housing, the high-voltage housing and/or the low-voltage housing being in each case gas- and/or liquid-impervious. This can therefore involve separate housings which reduce in each case themselves a hazard to users as a result of escaping voltages. In order to enable contact-free measurement, wall regions can be present on the high-voltage housing and/or on the low-voltage housing which allow the penetration of the measurement signal. For example, windows can be present in walls or entire walls or the entire housing can be configured to be permeable for the signal.

In one particularly advantageous configuration, the contacts can be arranged in a high-voltage housing and the detector can be arranged in a low-voltage housing which can be joined together with the high-voltage housing. In a first embodiment, the high-voltage housing is gas- and/or liquid-impervious in the joined-together state. In particular, the high-voltage housing does not have to be gas- or liquid-impervious in the non-joined together state, but rather can only become gas- and/or liquid-impervious by joining together with the low-voltage housing. Manufacture and maintenance are simplified in the case of such a configuration.

A gas- and/or liquid-impervious configuration of the housing(s) or of the contact switching chamber is not always necessary. Above all, a voltage-impervious, in particular high-voltage impervious configuration is advantageous. A dust-impervious configuration is furthermore advantageous.

In a second embodiment, the high-voltage housing together with the low-voltage housing in the joined-together state forms a gas- and/or liquid-impervious entire housing. In this case too, the high-voltage housing and/or the low-voltage housing do not have to be gas- and/or liquid-impervious in the as yet non-joined-together state. Such sealing can only be achieved by joining together the two housings. The manufacturing method is also simplified in the case of such a configuration.

In one simple configuration, the housing is formed at least partially by walls of the contact switching chamber and at least partially by walls of a detector chamber. As a result, the number of components required is reduced.

In order to produce a simple adjustment of the position of the detector relative to the element to be measured, the switching arrangement can have adjustment means. These can enable, for example, the position of the detector in all three spatial directions and along different angles.

The detector which performs contact-free measurement is a magnetic field sensor, namely a hall sensor. Such a magnetic field hall sensor can detect the strength or the change in the strength of a magnetic field. The magnetic field can be generated, for example, by an attached magnet, in particular a permanent magnet. If further magnetic field-generating elements, such as a coil, are present, this can lead to the magnetic field sensor only being used for detection if these elements are not activated, for example, if the coil is current-free. This can be, for example, in a separated position.

The detector can have a signal output at which a first signal is emitted if the switching device is located in the separated position and at which at least one further signal which is different from the first signal is transmitted if the switching device is not located in the separated position. Such a configuration enables a simple signal evaluation. A second signal which is different from the first and further signals can be transmitted at the signal output if the switching device is located in a bridging position in which the contacts are connected to one another by the switching device. As a result, positive feedback that the switching device is located in the bridging position can be generated. Further signals can be present at the signal output, in particular a continuous or quasi-continuous signal region can be present between the first signal and the second signal so that, for example, a position of the switching device can be determined more accurately. This allows more accurate monitoring of the movement of the switching device.

The solution according to the invention also comprises a switch for a switching arrangement or switching assembly according to the invention. Such a switch is configured to enable measurement with the detector, namely the hall sensor, which performs contact-free measurement. For this purpose, a signal-permeable wall region can be present which enables a measurement signal to pass through. For example, such a wall region can be an opening or a window.

In particular, the wall region can be gas- and/or liquid-impervious and/or high-voltage-impervious so that no high voltage can escape. For example, a window can be fitted in an opening of a wall. In one method according to the invention, the detection can be carried out through a housing wall.

The invention is explained by way of example in greater detail below with reference to the drawings. The advantageous configurations and further developments shown therein are themselves each advantageous and which can be combined with one another in any desired manner.

In the drawings.
- Fig. 1: shows a schematic view of a cross-section through a switching arrangement not covered by the present invention.
- Fig. 2: shows a schematic, sectional perspective view of a switch;
- Fig. 3A, 3B: show details of a further embodiment of a switching arrangement according to the invention.

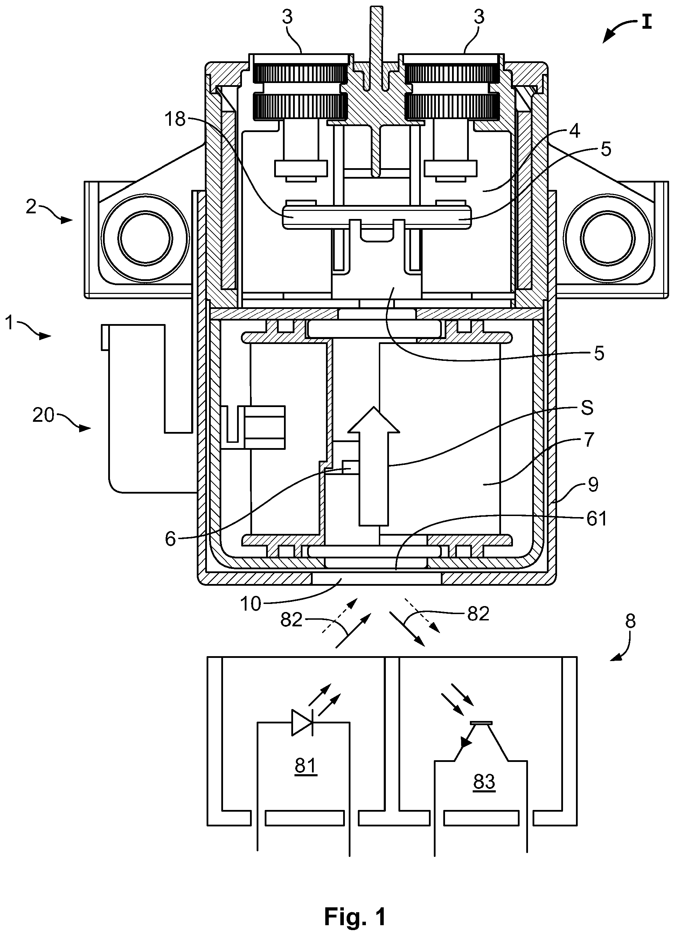

A switching arrangement 1, not covered by the present invention, is represented in Fig. 1. Switching arrangement 1 comprises a switch 2 with two contacts 3 which are arranged in a contact switching chamber 4. A switching device 5 serves to establish or disconnect an electric connection between the two contacts 3. For this purpose, switching device 5 is movable between separated position I represented in Fig. 1, in which contacts 3 are electrically separated from one another, and a bridging position, in which contacts 3 are connected to one another in an electrically conductive manner by switching device 5.

Switching device 5 comprises a contact bridge 18 and an armature 6. Armature 6 is arranged in a coil 7 which is represented partially cut away in Fig. 1 in order to enable a view of further elements. Depending on whether and at which strength and in which direction a current flows in the coil, armature 6, and thus switching device 5, is moved in or counter to switching direction S and switch 2 is thus electrically conductive or electrically insulating between contacts 3. Armature 6 represents a part of a drive 20 for contact bridge 18.

In particular high currents or high voltages, such as are used, for example, in electric driven cars, may be present at contacts 3. Electric contacts 3 can weld to switching device 5 during use. This can lead to it no longer being possible to open switch 2, i.e. adequate insulation can no longer be achieved. This results in a hazard, for example, when maintenance personnel are carrying out work. In order to be able to ensure that switch 2 is adequately insulated, switching arrangement 1 has a detector 8 which detects the position of switching device 5. In particular, it detects whether switching device 5 is in separated position I. For this purpose, detector 8 is aligned towards the region of a rear side 61 of armature 6.

The detector is a detector 8 which performs optical measurement 8. Detector 8 is designed as a reflection light barrier. Detector 8 comprises a transmitter 81 which transmits a light beam 82. Light beam 82 is reflected in different ways in the region of rear side 61 of armature 6 depending on the position of armature 6 and of rear side 61 so that, depending on the position of rear side 61, more or less light of light beam 82 is reflected into a receiver 83. Receiver 83 converts the light into an electric signal so that downstream electronics (not represented) can evaluate whether switching device 5 is in separated position I or not.

Detector 8 can also be configured so that the presence of switching device 5 in the bridging position is detected.

In the case of a sufficiently high temporal and/or spatial resolution, the movement of switching device 5 and/or the movement of armature 6 can be measured over the entire armature stroke with temporal and/or spatial resolution. Such a measurement can be used, for example, to identify wear of the switching device. Such wear can be exhibited, for example, in that the stroke of armature 6 and/or switching device 5 becomes longer and/or is displaced along switching direction S. A changed movement profile can also indicate wear. Such a changed movement profile can be identified, for example, by contrasting earlier and current location/time characteristics. In particular, for example, the position of armature 6 at the point in time of closing of contacts 3 and the end location of armature 6 can be measured. Wear can then be concluded from this data since this length is extended with increasing service life.

In order to enable light beam 82 to strike rear side 61 of armature 6, housing 9 of switch 2 has a signal-permeable wall region 10 which is configured as an opening or recess in the configuration according to Fig. 1. In other configurations, a signal-permeable wall region 10 can, for example, also consist of a transparent window. In the case of such a configuration, wall region 10 allows the signals required for measurement to pass through, but enables sealing of housing 9, in particular a gas- and/or liquid-impervious sealing and high-voltage-impervious sealing. Signal-permeable wall region 10 is arranged on a rear side of housing 9. Drive 20 lies between contact bridge 18 and wall region 10. Moreover, the drive lies between contact bridge 18 and detector 8. Drive 20 lies outside housing 9. Gas- and liquid-impervious sealing is not absolutely essential. Voltage-impervious, in particular high-voltage-impervious sealing is usually sufficient. Dust-impervious sealing is also advantageous.

Wall region 10 lies in the region of coil 7, i.e. in the region of drive 20. It allows a direct sensing of an element of drive 20, namely of armature 6, without further intermediate elements.

In the case of the embodiment represented in Fig. 1, detector 8 and switch 2 are separated from one another. Both are located in each case in their own housings. In alternative configurations, detector 8 and switch 2 can be unified in a single housing 9. Such as housing can as a whole be gas- and/or liquid- and/or high-voltage-impervious. There can be present in such a housing 9 a high-voltage region in which contacts 3 are arranged and a low-voltage region in which low-voltage-operated elements, for example, detector 8, are arranged. Both regions can be separated from one another by a signal-permeable wall region 10, in particular separated from one another in a gas- and/or liquid- and/or high-voltage-impervious manner.

In one configuration, which is similar to the configuration of Fig. 1, the contacts can be arranged in a first housing and detector 8 can be arranged in a second housing 9. The housing with contacts 3 is a high-voltage housing, the housing with detector 8 is a low-voltage housing. The two housings can be able to be joined together so that the high-voltage housing is sealed off in a high-voltage-proof manner only in the joined-together state, for example, because open points, for example, a wall region 10 can also be sealed off by the low-voltage housing. In particular, the high-voltage housing and the low-voltage housing in the joined-together state can produce an entire housing which is gas- and/or liquid- and/or high-voltage-impervious, while in the non-joined-together state at least one housing is not gas- and/or liquid- and/or voltage-impervious.

The detector is directed towards drive 20. A direct detection of the position of contact bridge 18 is not necessary. Detector 8 is arranged on the side of drive 20 which faces away from contacts 3. A wall region 10 which is permeable for the signals of the measurement with detector 8 is arranged between detector 8 and drive 20. This arrangement, in particular the fact that detector 8 is not arranged in the vicinity of contacts 3, in particular not in contact switching chamber 4 or in housing 9, leads to detector 8 being protected since it is in particular not exposed to the loads or contamination during the switching process. In particular, it is not exposed to the arc plasma which occurs during opening.

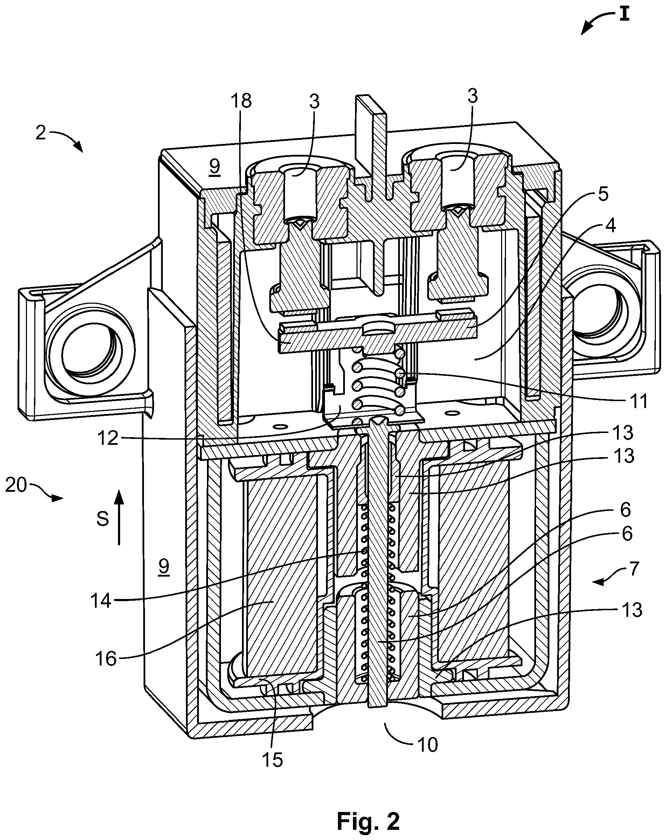

A partially sectional view of a switch 2 is represented in perspective in Fig. 2. Switching device 5 again connects contacts 3 in an electrically conductive manner if it is located in a bridging position, not represented. For this purpose, switching element 5 comprises an armature 6 and a contact bridge 18 connected thereto. The connection here is indirectly via a connection element 11. A spring 12 presses the contact bridge against an upper side of connection element 11 or, in the bridging state, against contacts 3. Armature 6 is arranged in friction bearings 13 which are arranged in a coil 7. Here, a spring 14 prestresses the armature in the direction of separated position I. Coil 7 comprises a coil body 15 and windings 16 which are only represented schematically.

Signal-permeable wall region 10, which is configured here as an opening in housing 9, is particularly apparent. The position of armature 6 and thus of switching device 5 can be detected in a contact-free manner through wall region 10. As a result of the contact-free sensing, it is ensured that no high voltage is transmitted to the detector.

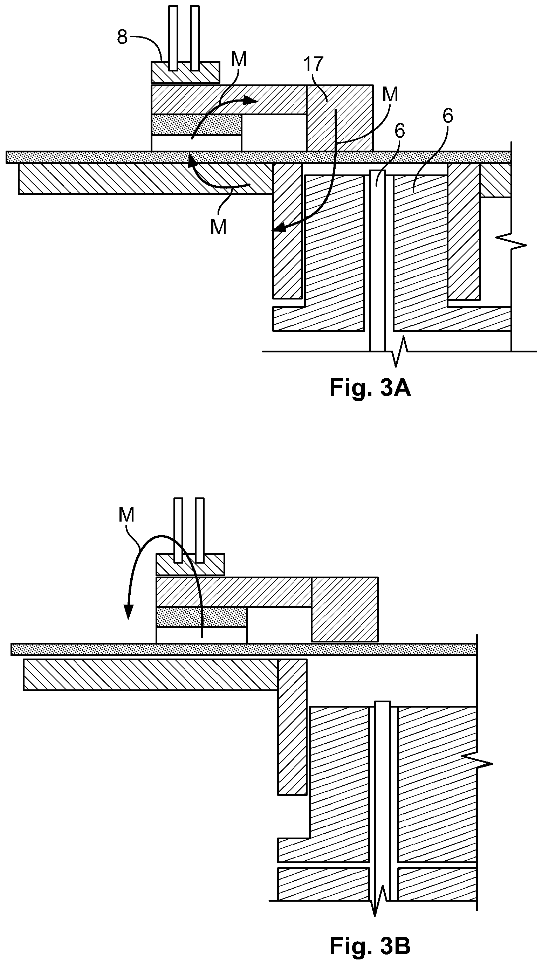

Details of a different configuration of a switching arrangement 1 are represented schematically in Fig. 3A and 3B, in the case of which a contact-free measurement of the position of armature 6 is also carried out. Detector 8 used here comprises a sensor which can measure a magnetic field. This involves a Hall sensor. Depending on the position of armature 6, a magnetic circuit 17 is closed or open so that the Hall sensor measures a different direction and/or intensity of magnetic field M. The position of the armature and of switching element 5 connected thereto can thus also be deduced. Again, the measurement is carried out in a contact-free manner.

### List of reference signs

- 1: Switching arrangement
- 2: Switch
- 3: Contact
- 4: Contact switching chamber
- 5: Switching device
- 6: Armature
- 7: Coil
- 8: Detector, magnetic field sensor
- 9: Housing
- 10: Wall region
- 11: Contact Spring
- 12: Connection element
- 13: Bush bearing
- 14: Release Spring
- 15: Coil body
- 16: Winding
- 17: Sensor flux guide
- 18: Contact bridge
- 20: Motor
- 61: Rear side of the armature
- 81: Light source
- 82: Light beam
- 83: Light sensor

- I: Rest position
- S: Switching direction

## Claims

1. A switching arrangement (1), in particular for the high-voltage and/or high-current region, with two contacts (3) and a switching device (5), which can be moved into a rest position (I) in which the contacts (3) are electrically separated from one another, wherein the switching arrangement (1) comprises a detector (8) with which the presence of the switching device (5) in the separated position (I) and in a bridging position, in which the contacts (3) are connected to one another by the switching device (5), can be detected in a contact-free manner, wherein the detector (8), which performs measurement in the contact-free manner, is a hall sensor, wherein the switching device (5) comprises an armature (6) arranged in a coil (7), wherein the position of the armature (6) can be detected in a contact-free manner with the detector (8) wherein depending on the position of the armature (6), a magnetic circuit (17) is closed or open, and wherein the detector (8) is configured to detect an infinite number of intermediate positions between the separated position (I) and the bridging position so that a determination of the position of the switching device (5) in a continuous region between the separated position (I) and the bridging position is possible, **characterized in that** the switching arrangement (1) is adapted to identify a wear of the switching device (5) or the contacts (3) by measurement of the position of the armature (6).

2. The switching arrangement (1) according to claim 1, wherein the switching device (5) comprises a motor (20) for a contact bridge (18), and the detector is directed towards the motor (20).

3. The switching arrangement (1) according to any one of claims 1 or 2, wherein the contacts (3) are arranged inside a housing (9) and the detector (8) is arranged outside the housing (9).

4. The switching arrangement (1) according to any one of claims 1 to 3, wherein the contacts (3) are arranged in a high-voltage housing and/or the detector (8) is arranged in a low-voltage housing and the high-voltage housing and/or the low-voltage housing are gas- and/or liquid-tight.

5. The switching arrangement (1) according to any one of claims 1 to 2 or 4, wherein the switching arrangement (1) comprises a housing (9) which comprises a high-voltage region and a low-voltage region, wherein the contacts (3) are arranged in the high-voltage region and the detector (8) is arranged in the low-voltage region

6. The switching arrangement (1) according to any one of claims 1 to 5, wherein the detector (8) has a signal output at which a first signal is emitted if the switching device (5) is located in the rest position (I) and at which at least one further signal which is different from the first signal is emitted if the switching device (5) is not located in the rest position (I).

7. A switch (2) for a switching arrangement (1) according to any one of claims 1 to 6, wherein a wall of a housing (9) of the switch (2) has a signal-permeable wall region (10).

8. A method for measuring the switching state of a switching arrangement (1) with two contacts (3) and a switching device (5), which can be moved into a rest position (I) in which the contacts (3) are electrically separated from one another, wherein the presence of the switching device (5) in the rest position (I) and in a bridging position, in which the contacts (3) are connected to one another by the switching device (5), is detected by a contact-free measurement of the position of the switching device (5) by a hall sensor, wherein the switching device (5) comprises an armature (6) arranged in a coil (7) and the position of the armature (6) is detected in a contact-free manner, wherein depending on the position of the armature (6), a magnetic circuit (17) is closed or open, and wherein an infinite number of intermediate positions between the separate position (I) and the bridging position is detected by the Hall sensor so that the position of the armature (6) is determined in a continuous region between the rest position (I) and the bridging position, **characterized in that** a wear of the switching device (5) or the contacts (3) is identified by measuring the position of the armature (6).

9. The method according to claim 8, wherein detection is carried out through a housing wall.

## Patentansprüche

1. Schaltanordnung (1), insbesondere für den Hochspannungs- und/oder Hochstrombereich, mit zwei Kontakten (3) und einer Schalteinrichtung (5), die in eine Ruhestellung (I) bewegt werden kann, in der die Kontakte (3) elektrisch voneinander getrennt sind, wobei die Schaltanordnung (1) einen Detektor (8) umfasst, mit dem das Vorhandensein der Schalteinrichtung (5) in der Trennstellung (I) und in einer Überbrückungsstellung, in der die Kontakte (3) über die Schalteinrichtung (5) miteinander verbunden sind, berührungslos erfasst werden kann, wobei der Detektor (8), der Messung berührungslos durchführt, ein Hall-Sensor ist, die Schalteinrichtung (5) einen in einer Spule (7) angeordneten Anker (6) umfasst, die Stellung des Ankers (6) mit dem Detektor (8) berührungslos erfasst werden kann, und in Abhängigkeit von der Stellung des Ankers (6) ein Magnetkreis (17) geschlossen oder offen ist, und der Detektor (8) so ausgeführt ist, dass er eine unbegrenzte Anzahl von Zwischenstellungen zwischen der Trennstellung (I) und der Überbrückungsstellung so erfasst, dass eine Bestimmung der Stellung der Schalteinrichtung (5) in einem durchgehenden Bereich zwischen der Trennstellung (I) und der Überbrückungsstellung möglich ist, **dadurch gekennzeichnet, dass** die Schaltanordnung (1) so eingerichtet ist, dass sie einen Verschleiß der Schalteinrichtung (5) oder der Kontakte (3) durch Messung der Stellung des Ankers (6) identifiziert.

2. Schaltanordnung (1) nach Anspruch 1, wobei die Schalteinrichtung (5) einen Motor (20) für eine Kontaktbrücke (18) umfasst und der Detektor auf den Motor (20) zu gerichtet ist.

3. Schaltanordnung (1) nach einem der Ansprüche 1 oder 2, wobei die Kontakte (3) innerhalb eines Gehäuses (9) angeordnet sind und der Detektor (8) außerhalb des Gehäuses (9) angeordnet ist.

4. Schaltanordnung (1) nach einem der Ansprüche 1 bis 3, wobei die Kontakte (3) in einem Hochspannungs-Gehäuse angeordnet sind und/oder der Detektor (8) in einem Niederspannungs-Gehäuse angeordnet ist und das Hochspannungs-Gehäuse und/oder das Niederspannungs-Gehäuse gas- und/oder flüssigkeitsdicht sind/ist.

5. Schaltanordnung (1) nach einem der Ansprüche 1 bis 2 oder 4, wobei die Schaltanordnung (1) ein Gehäuse (9) umfasst, das einen Hochspannungs-Bereich sowie einen Niederspannungs-Bereich umfasst, wobei die Kontakte (3) in dem Hochspannungs-Bereich angeordnet sind und der Detektor (8) in dem Niederspannungs-Bereich angeordnet ist.

6. Schaltanordnung (1) nach einem der Ansprüche 1 bis 5, wobei der Detektor (8) einen Signalausgang aufweist, an dem ein erstes Signal ausgegeben wird, wenn sich die Schalteinrichtung (5) in der Ruhestellung (I) befindet, und an dem wenigstens ein weiteres Signal ausgegeben wird, das sich von dem ersten Signal unterscheidet, wenn sich die Schalteinrichtung (5) nicht in der Ruhestellung (I) befindet.

7. Schalter (2) für eine Schaltanordnung (1) nach einem der Ansprüche 1 bis 6, wobei eine Wand eines Gehäuses (9) des Schalters (2) einen signaldurchlässigen Wandbereich (10) aufweist.

8. Verfahren zum Messen des Schaltzustandes einer Schaltanordnung (1) mit zwei Kontakten (3) und einer Schalteinrichtung (5), die in eine Ruhestellung (I) bewegt werden kann, in der die Kontakte (3) elektrisch voneinander getrennt sind, wobei das Vorhandensein der Schalteinrichtung (5) in der Trennstellung (I) und in einer Überbrückungsstellung, in der die Kontakte (3) über die Schalteinrichtung (5) miteinander verbunden sind, durch eine berührungslose Messung der Stellung der Schalteinrichtung (5) mittels eines Hall-Sensors erfasst wird, die Schalteinrichtung (5) einen in einer Spule (7) angeordneten Anker (6) umfasst und die Stellung des Ankers (6) berührungslos erfasst wird, und in Abhängigkeit von der Stellung des Ankers (6) ein Magnetkreis (17) geschlossen oder offen ist, und eine unbegrenzte Anzahl von Zwischenstellungen zwischen der Trennstellung (I) und der Überbrückungsstellung mit dem Hall-Sensor so erfasst wird, dass die Stellung des Ankers (6) in einem durchgehenden Bereich zwischen der Ruhestellung (I) und der Überbrückungsstellung erfasst wird, **dadurch gekennzeichnet, dass** ein Verschleiß der Schalteinrichtung (5) oder der Kontakte (3) durch Messen der Stellung des Ankers (6) identifiziert wird.

9. Verfahren nach Anspruch 8, wobei Erfassung durch eine Gehäusewand hindurch ausgeführt wird.

## Revendications

1. Agencement de commutation (1), en particulier pour la zone haute tension et/ou la zone haute intensité, avec deux contacts (3) et un dispositif de commutation (5), qui peut être déplacé vers une position de repos (|) dans laquelle les contacts (3) sont séparés électriquement l'un de l'autre, dans lequel l'agencement de commutation (1) comprend un détecteur (8) avec lequel la présence du dispositif de commutation (5) dans la position séparée (|) et dans une position de pontage, dans laquelle les contacts (3) sont connectés l'un à l'autre par le dispositif de commutation (5), peut être détecté de manière sans contact, dans lequel le détecteur (8), qui effectue une mesure de manière sans contact, est un capteur à effet Hall, dans lequel le dispositif de commutation (5) comprend une armature (6) disposée dans une bobine (7), dans lequel la position de l'armature (6) peut être détectée de manière sans contact avec le détecteur (8) dans lequel selon la position de l'armature (6), un circuit magnétique (17) est fermé ou ouvert, et dans lequel le détecteur (8) est configuré pour détecter un nombre infini de positions intermédiaires entre la position séparée (|) et la position de pontage de sorte qu'une détermination de la position du dispositif de commutation (5) dans une zone continue entre la position séparée (|) et la position de pontage soit possible, **caractérisé en ce que** l'agencement de commutation (1) est adapté pour identifier une usure du dispositif de commutation (5) ou des contacts (3) par une mesure de la position de l'armature (6).

2. L'agencement de commutation (1) selon la revendication 1, dans lequel le dispositif de commutation (5) comprend un moteur (20) pour un pont de contact (18), et le détecteur est dirigé vers le moteur (20) .

3. L'agencement de commutation (1) selon l'une quelconque de la revendication 1 ou 2, dans lequel les contacts (3) sont disposés à l'intérieur d'un boîtier (9) et le détecteur (8) est disposé à l'extérieur du boîtier (9).

4. L'agencement de commutation (1) selon l'une quelconque des revendications 1 à 3, dans lequel les contacts (3) sont disposés dans un boîtier de haute tension et/ou le détecteur (8) est disposé dans un boîtier de basse tension, et le boîtier de haute tension et/ou le boîtier de basse tension sont étanches aux gaz et/ou aux liquides.

5. L'agencement de commutation (1) selon l'une quelconque des revendications 1 à 2 ou 4, dans lequel l'agencement de commutation (1) comprend un boîtier (9) qui comprend une zone de haute tension et une zone de basse tension, dans lequel les contacts (3) sont disposés dans la zone de haute tension et le détecteur (8) est disposé dans la zone de basse tension.

6. L'agencement de commutation (1) selon l'une quelconque des revendications 1 à 5, dans lequel le détecteur (8) présente une sortie de signal au niveau de laquelle un premier signal est émis si le dispositif de commutation (5) est placé dans la position de repos (|) et au niveau de laquelle au moins un autre signal qui est différent du premier signal est émis si le dispositif de commutation (5) n'est pas placé dans la position de repos (|).

7. Commutateur (2) pour un agencement de commutation (1) selon l'une quelconque des revendications 1 à 6, dans lequel une paroi d'un boîtier (9) du commutateur (2) présente une zone de paroi perméable en termes de signal (10) .

8. Procédé pour mesurer l'état de commutation d'un agencement de commutation (1) avec deux contacts (3) et un dispositif de commutation (5), qui peut être déplacé vers une position de repos (1) dans laquelle les contacts (3) sont séparés électriquement l'un de l'autre, dans lequel la présence du dispositif de commutation (5) dans la position de repos (1) et dans une position de pontage, dans laquelle les contacts (3) sont connectés l'un à l'autre par le dispositif de commutation (5), est détectée par une mesure sans contact de la position du dispositif de commutation (5) par un capteur à effet Hall, dans lequel le dispositif de commutation (5) comprend une armature (6) disposée dans une bobine (7) et la position de l'armature (6) est détectée de manière sans contact, dans lequel selon la position de l'armature (6), un circuit magnétique (17) est fermé ou ouvert, et dans lequel un nombre infini de positions intermédiaires entre la position séparée (|) et la position de pontage est détecté par le capteur à effet Hall de sorte que la position de l'armature (6) soit déterminée dans une zone continue entre la position de repos (|) et la position de pontage, **caractérisé en ce qu'**une usure du dispositif de commutation (5) ou des contacts (3) est identifiée en mesurant la position de l'armature (6).

9. Le procédé selon la revendication 8, dans lequel une détection est effectuée à travers une paroi de boîtier.
